# EUROPEAN PATENT APPLICATION

(11) **EP 4 206 812 A1**
(43) Date of publication of application: **05.07.2023**
(21) Application number: 22171761.4
(22) Date of filing: 05.05.2022
(51) Int. Cl.: G02F 1/1675

(54) **PROTECTIVE FILM STRUCTURE AND E-PAPER DISPLAY DEVICE**

(30) Priority: 30.12.2021 TW 110149771
(71) Applicant: SES-imagotag SA, 92000 Nanterre (FR)
(72) Inventor: YANG, Chin-An, 74144 Tainan City (TW); WANG, Yew-Chun, 74144 Tainan City (TW)
(74) Representative: Zimmermann, Tankred Klaus

(57) **Abstract**

An e-paper display device includes a driving substrate, an e-paper film, and a protective film structure. The e-paper film is arranged on a surface of the driving substrate. The protective film structure is arranged on the driving substrate and includes a laminated structure including a base material layer, a barrier layer and a waterproof adhesive layer. The barrier layer is located between the base material layer and the waterproof adhesive layer, and the protective film structure is arranged on the driving substrate through the waterproof adhesive layer and covering the e-paper film. The protective film structure has a main portion and an extension portion arranged around the main portion. The main portion is attached to the top surface of the e-paper film, and the extension portion is attached to the surface of the driving substrate.

## Description

### BACKGROUND

### Technology Field

This invention relates to a protective structure and, in particular, to a protective film structure and an e-paper display device.

### Description of Related Art

With the advancement of technologies, the e-paper display device, which is one of the human-machine interfaces (HMI), is continuously improved and developed in the diversified applications to meet the needs of human beings. Since the e-paper display device is a sensitive high-tech product, if moisture or dusts invades into the e-paper display device, it may damage its normal operation. Therefore, a protective film is generally attached to the display surface to protect the e-paper display device from external moisture or dusts, thereby improving the lifetime of the e-paper display device.

However, in order to achieve a better protection effect, the conventional protective film usually includes many layers, which means that the conventional protective film is manufactured by many manufacturing steps, so that the manufacturing cost of the e-paper display device is relatively higher.

### SUMMARY

One or more exemplary embodiment of this invention is to provide a protective film structure and an e-paper display device having the same, which have a lower manufacturing cost, fewer manufacturing steps, and improved optical effects.

In an exemplary embodiment, an e-paper display device includes a driving substrate, an e-paper film and a protective film structure. The driving substrate has a surface, and the e-paper film is arranged on the surface of the driving substrate. The protective film structure is arranged on the driving substrate and includes a laminated structure, which includes a base material layer, a barrier layer and a waterproof adhesive layer. The barrier layer is located between the base material layer and the waterproof adhesive layer, and the protective film structure is arranged on the driving substrate through the waterproof adhesive layer and covers the e-paper film. The protective film structure includes a main portion and an extension portion. The extension portion is arranged around the periphery of the main portion. The main portion is attached to the top surface of the e-paper film away from the driving substrate, and the extension portion is attached to the surface of the driving substrate.

In an exemplary embodiment, a protective film structure includes a base material layer, a waterproof adhesive layer and a barrier layer. The protective film structure is applied with a driving substrate and an e-paper film, and the e-paper film is arranged on a surface of the driving substrate. The barrier layer is located between the base material layer and the waterproof adhesive layer, and the protective film structure is arranged on the driving substrate through the waterproof adhesive layer and covers the e-paper film. The protective film structure includes a main portion and an extension portion. The extension portion is arranged around the periphery of the main portion. The main portion is attached to a top surface of the e-paper film away from the driving substrate, and the extension portion is attached to the surface of the driving substrate.

In one embodiment, the protective film structure further includes a transition portion, and the transition portion connects the main portion to the extension portion.

In one embodiment, the material of the waterproof adhesive layer includes a cross-linked resin, an epoxy resin, or a combination thereof.

In one embodiment, the protective film structure further includes a functional layer, and the functional layer is arranged on a surface of the base material layer away from the barrier layer.

In one embodiment, the thickness of the protective film structure is greater than or equal to 50 µm and is less than or equal to 120 µm.

As mentioned above, in the protective film structure and e-paper display device of this invention, the barrier layer of the protective film structure is located between the base material layer and the waterproof adhesive layer, the protective film structure is arranged on the driving substrate through the waterproof adhesive layer and covers the e-paper film, the extension portion of the protective film structure is arranged around the periphery of the main portion, the main portion is attached to the top surface of the e-paper film away from the driving substrate, and the extension portion is attached to the surface of the driving substrate. Based on the above-mentioned design, the protective film structure and e-paper display device of this invention can have a lower manufacturing cost, fewer manufacturing steps, and improved optical effects.

### BRIEF DESCRIPTION OF THE DRAWINGS

The invention will become more fully understood from the detailed description and accompanying drawings, which are given for illustration only, and thus are not limitative of the present invention, and wherein:
FIG. 1A is a schematic diagram showing an e-paper display device according to an embodiment of this invention;
FIG. 1B is a sectional view of the e-paper display device of FIG 1A along the line A-A;
FIG. 1C is a schematic diagram showing the protective film structure of the e-paper display device of FIG. 1A;
FIG. 2A is a schematic diagram showing an e-paper display device according to a comparison example; and
FIG. 2B is a schematic diagram showing the protective film structure of the e-paper display device of FIG. 2A.

### DETAILED DESCRIPTION OF THE INVENTION

The present invention will be apparent from the following detailed description, which proceeds with reference to the accompanying drawings, wherein the same references relate to the same elements.

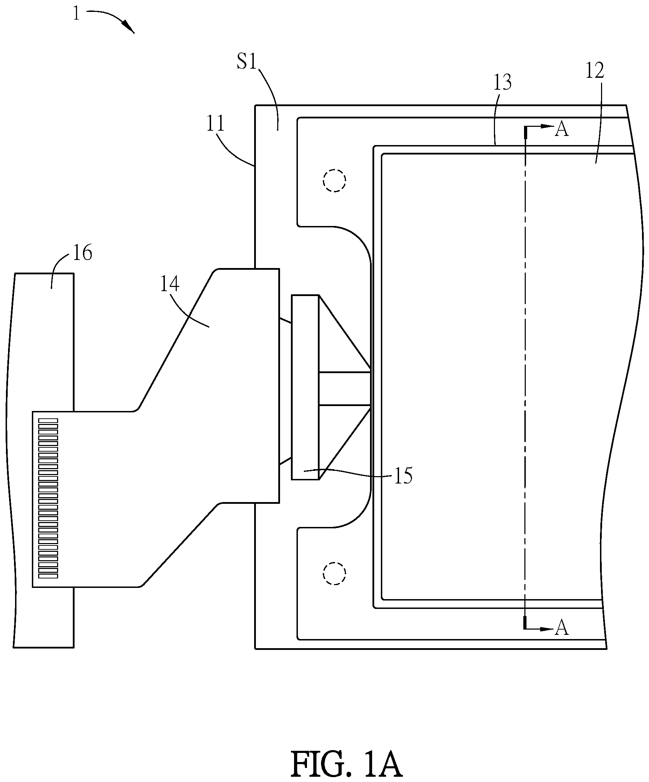

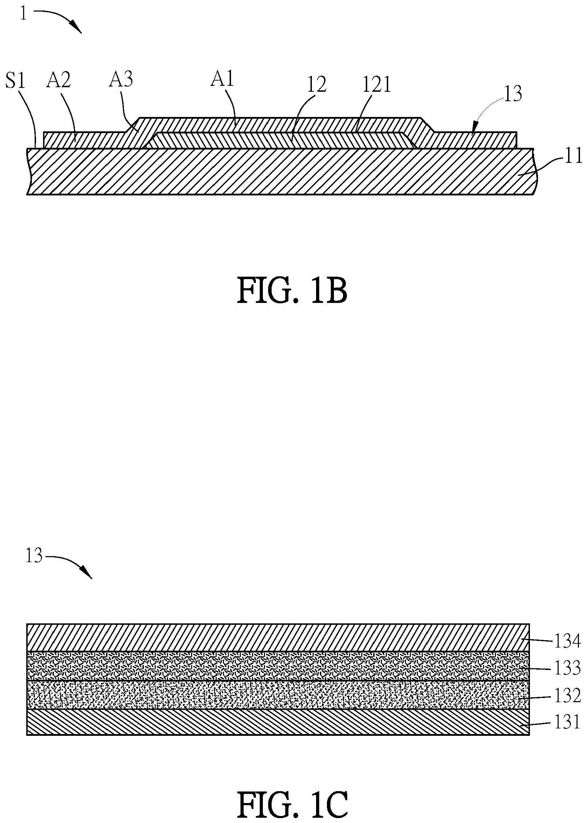

FIG. 1A is a schematic diagram showing an e-paper display device 1 according to an embodiment of this invention, FIG. 1B is a sectional view of the e-paper display device 1 of FIG. 1A along the line A-A, and FIG. 1C is a schematic diagram showing the protective film structure 13 of the e-paper display device 1 of FIG. 1A.

Referring to FIGS. 1A to 1C, the e-paper display device 1 includes a driving substrate 11, an e-paper film 12, and a protective film structure 13.

The driving substrate 11 has a surface S1, and the e-paper film 12 is arranged on the surface S1 of the driving substrate 11. The driving substrate 11 can control the e-paper film 12 to display image(s). In some embodiments, the driving substrate 11 includes a plurality of pixels, and each pixel has at least one switch, such as a thin-film transistor (TFT), so that the driving substrate 11 is an AM (Active Matrix) TFT substrate for controlling the electric field of each individual pixel. In some embodiments, the driving substrate 11 can be a PM (Passive Matrix) driving substrate, and this invention is not limited thereto. The base material of the driving substrate 11 can be changed based on the product requirement. In this embodiment, the driving substrate 11 can be a glass substrate, a plastic substrate, or a flexible substrate, and is configured with a pixel circuit. Herein, the material of the flexible substrate can be, for example but not limited to, polyimide (PI).

The e-paper film 12 is a bi-stable e-paper display device, which has the advantages of low power consumption and wide viewing angle. For example, the e-paper film 12 can be a microcapsule e-paper, a microcup e-paper, or a cholesteric liquid crystal e-paper, but this invention is not limited thereto. In some embodiments, when the e-paper film 12 is a microcapsule e-paper or a microcup e-paper, the display medium may include electrophoretic substances, and the electrophoretic substances include a plurality of charged light-colored pigment particles and a dark-colored medium solution. The pigment particles and the medium solution are respectively accommodated in a plurality of microcapsules, and an adhesive is used to bond the microcapsules. In another case, the electrophoretic substances may include dark-colored pigment particles and a light-colored medium solution. In another case, the electrophoretic substances may include pigment particles of multiple colors and a light-colored medium solution. This invention is not limited thereto.

The protective film structure 13 is a protective film with adhesive (PFA), which is arranged on the driving substrate 11 and covers the driving substrate 11. In some embodiments, the protective film structure 13 can be attached to the e-paper film 12 and the driving substrate 11 through an adhesive layer (e.g. OCA or OCR) for protecting the e-paper film 12. As shown in FIG. 1B, the protective film structure 13 includes a main portion A1, an extension portion A2 and a transition portion A3. The extension portion A2 is arranged around the periphery of the main portion A1, and the transition portion A3 is located between the main portion A1 and the extension portion A2 and connects the main portion A1 to the extension portion A2. In this embodiment, the main portion A1 is attached to the top surface 121 of the e-paper film 12 away from the driving substrate 11, and the extension portion A2 is attached to the surface S1 of the driving substrate 11. This configuration can completely protect the e-paper film 12 from the invasion of external moisture and dusts and improve the optical properties (e.g. contrast) and lifetime of the e-paper display device 1. In some embodiments, the thickness d of the protective film structure 13 can be greater than or equal to 40 µm and be less than or equal to 120 µm. In some embodiments, the thickness d of the protective film structure 13 can be greater than or equal to 50 µm and be less than or equal to 120 µm. For example, the thickness d of the protective film structure 13 can be 50 µm, 55 µm, 62 µm, or 118 µm.

As shown in FIG. 1C, the protective film structure 13 includes a laminated structure, which includes, from the bottom to the top, a waterproof adhesive layer 131, a barrier layer 132 and a base material layer 133. In addition, the protective film structure 13 of this embodiment further includes a functional layer 134. The barrier layer 132 is arranged between the base material layer 133 and the waterproof adhesive layer 131, and the protective film structure 13 is arranged on the driving substrate 11 through the waterproof adhesive layer 131 and covers the e-paper film 12. In this case, the waterproof adhesive layer 131 has the properties of waterproof and adhesion, and the material of the waterproof adhesive layer 131 can include, for example but not limited to, cross-linked resin, epoxy resin or the combination thereof. The barrier layer 132 can be a layer made of metal or non-metal materials, such as inorganic or organic material. The barrier layer 132 is configured to block the delivery of air or moisture so as to extend the lifetime of products. The material of the barrier layer 132 can include, for example, metal oxides, acrylic/silicon oxide hybrid material (Acrylic/SiₓO_{y}), or any combination thereof. The material of the base material layer 133 can include, for example, polyethylene terephthalate (PET), polyethylene (PE), tri-cellulose acetate (TAC), or any combination thereof. The functional layer 134 is arranged on a surface (top surface) of the base material layer 133 away from the barrier layer 132. The functional layer 134 is a light-permeable layer such as, for example but not limited to, an anti-glare film, an anti-reflection film, an anti-finger printing film, a waterproof film, an antifouling film, or an anti-scratch film, or a hard coating composed of any combination of the above functional layers, and this invention is not limited thereto.

Referring to FIG. 1A, the e-paper display device 1 of this embodiment may further include a connecting circuit board 14, a driving chip 15 and a system control board 16. The driving chip 15 is arranged on the driving substrate 11. Herein, the driving chip 15 is arranged on the driving substrate 11 by COG (Chip On Glass) technology. In some embodiments, the driving substrate 11 and the e-paper film 12 together form a display module, and the driving chip 15 further includes a scan driver or/and a data driver for the display module. In other words, the driving chip 15 has the scan driving function or the data driving function for driving the display module; or the driving chip 15 has the scan driving function and the data driving function (integrated function) for driving the display module. This invention is not limited thereto. The connecting circuit board 14 can be, for example but not limited to, a flexible circuit board, and connect to the driving chip 15 and the system control board 16. Accordingly, the system control bard 16 can transmit the control signals for driving the e-paper film 12 to the driving chip 15 and the driving substrate 11 through the connecting circuit board 14, thereby controlling the e-paper film 12 to display images.

Another e-paper display device 2 and the protective film structure 23 thereof according to a comparison example will be described hereinafter.

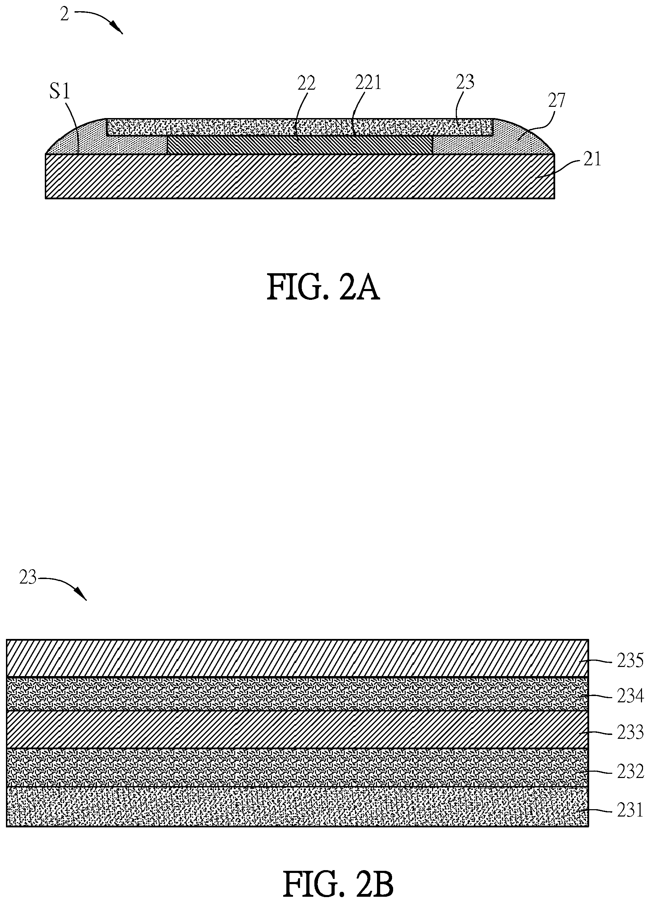

Referring to FIGS. 2A and 2B, the e-paper display device 2 also includes a driving substrate 21, an e-paper film 22 and a protective film structure 23. The e-paper film 22 is arranged on the driving substrate 21, and the protective film structure 23 covers the top surface 221 of the e-paper film 22 without directly contacting the surface S1 of the driving substrate 21. In addition, the e-paper display device 2 further includes a sealing member 27. For example, the sealing member 27 can be a sealant, which is arranged on the surface S1 of the driving substrate 11 and located at the periphery of the e-paper film 22 and the protective film structure 23. Accordingly, a part of the material of the sealing member 27 fills the gaps between the e-paper film 22 and the protective film structure 23. Moreover, in the comparison example of FIG. 2B, the protective film structure 23 includes, from the bottom to the top, a barrier layer 231 (e.g. a metal oxide layer), a first base material layer 232 (e.g. PET), an adhesive layer 233 (e.g. OCA), a second base material layer 234 (e.g. PET), and a functional layer 235 (e.g. an anti-glare film).

Comparing FIG. 1B and FIG. 2A, the laminated structure and materials of the protective film structure 13 of FIG. 1B are different from those of the protective film structure 23 of FIG. 2A. In addition, the arrangement of the protective film structure 13 on the driving substrate 11 is different from that of the protective film structure 23 of FIG. 2A. Moreover, the e-paper display device 1 can prevent the invasion of external moisture or dusts without configuring the sealing member (e.g. the sealing member 27 of FIG. 2A). As a result, the e-paper display device 1 and the protective film structure 13 of this invention have the advantages of less manufacturing steps, less materials required, and lower manufacturing cost.

Compared to the protective film structure 23 of FIG. 2B, the protective film structure 13 of FIG. 1C does not include the adhesive layer 233 and the second base material layer 234, but further includes a waterproof adhesive layer 131 for improving the water and moisture blocking effect. Accordingly, the number of total layers of the protective film structure 13 is less than that of the protective film structure 23, and the number of manufacturing steps of the protective film structure 13 is less than that of the protective film structure 23 by two. As shown in the following Table 1, in addition to the advantages of less manufacturing steps and lower manufacturing cost, the protective film structure 13 and the e-paper display device 1 of the above-mentioned embodiment can further improve the optical properties.

**Table 1**

| Item | RL^{∗} (Red Luminance) | Ra^{∗} (Red Color Space) | Rb^{∗} (Red Color Space) | WR% (White Reflection) | BR% (Brightness) | CR (Contrast Rate) |
|---|---|---|---|---|---|---|
| Improvement (%) | 7.16 | 0.43 | 34.74 | 2.57 | 17.60 | 15.20 |

In summary, in the protective film structure and e-paper display device of this invention, the barrier layer of the protective film structure is located between the base material layer and the waterproof adhesive layer, the protective film structure is arranged on the driving substrate through the waterproof adhesive layer and covers the e-paper film, the extension portion of the protective film structure is arranged around the periphery of the main portion, the main portion is attached to the top surface of the e-paper film away from the driving substrate, and the extension portion is attached to the surface of the driving substrate. Based on the above-mentioned design, the protective film structure and e-paper display device of this invention can have a lower manufacturing cost, fewer manufacturing steps, and improved optical effects.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. An e-paper display device, comprising:
a driving substrate having a surface;
an e-paper film arranged on the surface of the driving substrate; and
a protective film structure arranged on the driving substrate and comprising a laminated structure, wherein the laminated structure comprises a base material layer, a barrier layer and a waterproof adhesive layer, the barrier layer is located between the base material layer and the waterproof adhesive layer, and the protective film structure is arranged on the driving substrate through the waterproof adhesive layer and covers the e-paper film;
wherein, the protective film structure comprises a main portion and an extension portion, the extension portion is arranged around a periphery of the main portion, the main portion is attached to a top surface of the e-paper film away from the driving substrate, and the extension portion is attached to the surface of the driving substrate.

2. The e-paper display device of claim 1, wherein the protective film structure further comprises a transition portion, and the transition portion connects the main portion to the extension portion.

3. The e-paper display device of claim 1, wherein a material of the waterproof adhesive layer comprises a cross-linked resin, an epoxy resin, or a combination thereof.

4. The e-paper display device of claim 1, wherein the protective film structure further comprises a functional layer, and the functional layer is arranged on a surface of the base material layer away from the barrier layer.

5. The e-paper display device of claim 1, wherein a thickness of the protective film structure is greater than or equal to 50 µm and is less than or equal to 120 µm.

6. A protective film structure applied with a driving substrate and an e-paper film, the e-paper film arranged on a surface of the driving substrate, the protective film structure comprising:
a base material layer;
a waterproof adhesive layer; and
a barrier layer located between the base material layer and the waterproof adhesive layer, wherein the protective film structure is arranged on the driving substrate through the waterproof adhesive layer and covers the e-paper film;
wherein, the protective film structure comprises a main portion and an extension portion, the extension portion is arranged around a periphery of the main portion, the main portion is attached to a top surface of the e-paper film away from the driving substrate, and the extension portion is attached to the surface of the driving substrate.

7. The protective film structure of claim 6, further comprising:
a transition portion connecting the main portion to the extension portion.

8. The protective film structure of claim 6, wherein a material of the waterproof adhesive layer comprises a cross-linked resin, an epoxy resin, or a combination thereof.

9. The protective film structure of claim 6, wherein the protective film structure further comprises a functional layer, and the functional layer is arranged on a surface of the base material layer away from the barrier layer.

10. The protective film structure of claim 6, wherein a thickness of the protective film structure is greater than or equal to 50 µm and is less than or equal to 120 µm.
